# EUROPEAN PATENT APPLICATION

(11) **EP 4 624 211 A1**
(43) Date of publication of application: **01.10.2025**
(21) Application number: 25156325.0
(22) Date of filing: 06.02.2025
(51) Int. Cl.: B60K 1/00

(54) **IN-VEHICLE EQUIPMENT**

(30) Priority: 28.03.2024 JP 2024054697
(71) Applicant: MAZDA MOTOR CORPORATION, Hiroshima 730-8670 (JP)
(72) Inventor: Ichikawa, Hiroto, Aki-gun, Hiroshima, 730-8670 (JP); Ishikawa, Yasushi, Aki-gun, Hiroshima, 730-8670 (JP); Suemura, Hiroshi, Aki-gun, Hiroshima, 730-8670 (JP); Ramakrishnan, Shamit, Aki-gun, Hiroshima, 730-8670 (JP); Saiki, Hiroyuki, Aki-gun, Hiroshima, 730-8670 (JP); Yamasaki, Noriharu, Aki-gun, Hiroshima, 730-8670 (JP)
(74) Representative: Thoma, Michael

(57) **Abstract**

[Problem] To suppress careless access to an electrical connection portion of a power converter with a simple configuration.

[Solution] An in-vehicle device includes an inverter 10V and a protector 60 attached to the inverter 10V to protect the inverter 10V against interference with peripheral equipment during a vehicle collision. The inverter 10V includes an opening (service hole) 48, a terminal block 33 provided on an inside accessible through the opening 48, and a detachable lid 50 for closing the service hole 48. The protector 60 is provided to block an access path to the lid 50.

## Description

### [Technical Field]

The present invention relates to in-vehicle equipment that includes a power converter for converting electric power between a travel motor and a battery.

### [Background Art]

Electric vehicles such as electric cars and hybrid vehicles, each of which includes a travel motor and a power converter in a front space (front compartment) of the vehicle, have been well known. The power converter is a device that converts electric power between a battery and the travel motor.

In order to reduce loss of the electric power supplied to the travel motor, the power converter is often arranged on top of the travel motor or the like from a viewpoint of space efficiency.

The power converter is electrically connected to the battery and the travel motor. For example, such a structure is disclosed in JP 2018 111 420 A that a high-voltage battery and the power converter (power control unit) are connected by a power line. In this structure, one end of the power line is connected to a high-voltage connector that is provided in the power converter.

In addition, such a structure is disclosed in JP 2009 389 20 A that the power converter (PCU) and the travel motor (motor generator) are connected by the power line (power cable). In this structure, a housing for the travel motor is provided with a cylindrical portion in which a connector is accommodated, and the power line penetrates the cylindrical portion and is connected to the connector. An opening of the cylindrical portion is closed by a connector cover.

### [Citation List]

### [Patent Literature]

[Patent Literature 1] JP2018-111420A
[Patent Literature 2] JP2009-38920A

### [Summary of Invention]

### [Technical Problem]

An electrical connection portion in the power converter is often configured by a terminal block having a bare terminal, and direct contact with the terminal block is possibly a risk of electric shock. Accordingly, preferably, as in the structure disclosed in JP 2009 389 20 A, it is desired to close the opening by a cover (lid) by surrounding the electrical connection portion with the housing or the like and thereby prevent unintentional contact with the electrical connection portion.

However, in the structure disclosed in JP 2009 389 20 A, the cover is bolted to the cylindrical portion and thus can be detached therefrom relatively easily. Thus, even a person without expert knowledge can easily detach the cover, which is problematic in terms of safety. In this case, for example, it is also considered to provide an interlock mechanism that forcibly shuts off energization when the cover is detached. However, such a configuration requires high cost, and thus is difficult to be actually introduced.

The invention has been made in view of the circumstance as described above and therefore has a purpose of providing in-vehicle device capable of suppressing careless access to an electrical connection portion in a power converter by a simple configuration.

### [Solution to Problem]

The invention has been made in view of the above problem and includes: a power converter that is arranged in a compartment preferably in a front portion of a vehicle and converts electric power between a travel motor and a battery; and a protector that is attached to the power converter and protects the power converter against interference with peripheral equipment during a vehicle collision, in which the power converter includes: an opening; an electrical connection portion that is provided on an inside accessible through the opening; and a detachable lid member that closes the opening, and the protector is provided to block an access path to the lid member.

Here, "convert electric power" means that at least one of a voltage, a current, a frequency, a phase, and the number of the phases as variables of the electric power is converted into another form. For example, "convert electric power" means conversion between DC power and AC power, conversion to increase/reduce the voltage, or the like. In addition, the "access path" means a path through which a hand of a person or a tool approaches the lid member for detachment of the lid member.

With this configuration, since the protector is provided to block the access path to the lid member, the protector becomes an obstacle for detaching the lid member. That is, in order to access the electrical connection portion, it is required to detach the lid member after detaching the protector, and an increase in workload in this manner serves as a deterrent against easy detachment action of the lid member. Thus, it is possible to suppress careless access to the electrical connection portion with the simple configuration using the protector.

The protector may be provided to block an access path to a fixing member that fixes the lid member.

With this configuration, it is possible to suppress the careless access to the electrical connection portion with the further simple configuration to only block the access path to the fixing member for fixing the lid member by the protector.

The protector may be fixed to at least two positions or points including the lid member and a protector attachment portion that is provided in a place other than the lid member in the power converter.

With this configuration, in order to detach the protector, it is required to detach the protector from at least both of the protector attachment portion and the lid member. Since time and effort for detaching the protector is increased, just as described, the deterrent against detachment action of the lid member is improved. Thus, it is possible to further highly suppress the careless access to the electrical connection portion.

The protector may be fixed to the lid member at a different point from the point at which the lid member is fixed. That is, it is preferably configured that the protector and the lid member are not integrally fixed by co-fastening.

With this configuration, in order to access the electrical connection portion, it is required to detach the protector from both of the protector attachment portion and the lid member and then further detach the lid member. That is, detachment work is required for three places. Thus, the deterrent against the detachment action of the lid member is further improved.

It may be configured that, when the protector attachment portion is defined as a first protector attachment portion, the lid member may have a second protector attachment portion that is a portion in which the protector is fixed to the lid member and which is formed to have lower rigidity than another portion of the lid member in a manner to be deformed during interference between the peripheral equipment and the protector.

With this configuration, when the peripheral equipment and the protector collide with each other during the vehicle collision or the like, the second protector attachment portion is deformed, and collision energy is thereby absorbed. Thus, it is possible to avoid substantial damage to the lid member and thus damage to the electrical connection portion.

The protector may have a priority interference portion that preferentially interferes with the peripheral equipment during the vehicle collision, and in the power converter, the electrical connection portion may be provided at a position away from the priority interference portion. In particular, the priority interference portion may be a portion that first contacts the peripheral equipment during a collision.

With this configuration, the electrical connection portion is provided at the position away from the priority interference portion of the protector. Thus, even when the peripheral equipment collides with the protector, the electrical connection portion is less likely to be damaged.

According to another aspect, it may be configured that the protector has an interference portion that is a portion interfering with the peripheral equipment during the vehicle collision and including a guide surface for relatively moving the peripheral equipment in an up-down direction, and that the protector attachment portion is provided below the interference portion.

With this configuration, the protector attachment portion is hidden under the interference portion and thus is difficult to be visually recognized. Thus, the deterrent against the detachment action of the lid member is further improved.

According to another aspect, the guide surface may be an inclined surface.
According to another aspect, the power converter may include a temporary placement portion of the lid member, the lid member may be fixed in a state of being temporarily placed on the temporary placement portion, and the temporary placement portion may be provided to allow displacement of the lid member in only one direction that is an attachment/detachment direction.

With this configuration, when the lid member is detached, the lid member has to be displaced in the one direction (attachment/detachment direction) and pulled away from the temporary placement portion. Thus, when the lid member is inclined or the like, the lid member cannot be pulled away from the temporary placement portion, which makes it difficult to detach the lid member. That is, it is difficult to smoothly detach the lid member. Thus, this configuration is useful in suppressing the careless access to the electrical connection portion.
According to another aspect of the present disclosure, the protector may comprise a baffle plate, which extends along the power converter in a width direction. Said baffle plate may comprise a cover portion that covers the lid member at least partially.
The baffle plate may further comprise a coupling portion and a fixed portion. The coupling portion may couple the cover portion and the fixed portion and the coupling portion may be oblique relative to the cover portion and relative to the fixed portion.
The lid member may comprise more than one fixing member, preferably four fixing members, for fixing the lid member. Furthermore, the cover portion may cover at least one of the fixing members.
The fixed portion may comprise paired fixed pieces, preferably paired belt-shaped fixed pieces, and optionally a support piece. The fixed portion may be fixed to a/the protector attachment portion, which may be provided in a place other than the lid member in the power converter, via the fixed pieces. The interference portion of the protector may be joined to the fixed pieces and optionally to the support piece.
According to another aspect, the protector may substantially have a crank-like shape in a plan view.
The present invention further relates to a vehicle with at least the in-vehicle device according to anyone of the preceding claims.

### [Advantageous Effects of Invention]

According to the invention that has been described so far, it is possible to suppress the careless access to the electrical connection portion in the power converter with the further simple configuration.

### [Brief Description of Drawings]

[FIG. 1] FIG. 1 is a plan view illustrating a schematic configuration of a vehicle that includes in-vehicle devices (an inverter and a protector) according to the invention.
[FIG. 2] FIG. 2 is a cross-sectional view illustrating the schematic configuration of the vehicle.
[FIG. 3] FIG. 3 is a schematic plan view of a powertrain that includes the inverter.
[FIG. 4] FIG. 4 is a view illustrating a power supply path from a battery.
[FIG. 5] FIG. 5 is a perspective view of the inverter (in a state of including the protector) according to a first embodiment.
[FIG. 6] FIG. 6 is a side view of the inverter.
[FIG. 7] FIG. 7 is a plan view of the inverter.
[FIG. 8] FIG. 8 is a back view of the inverter.
[FIG. 9] FIG. 9 includes views of the inverter alone, from which the protector is detached, in which FIG. 9A is a perspective view, and FIG. 9B is a back view.
[FIG. 10] FIG. 10 is a back view of the inverter in a state where a lid is detached from an opening (service hole).
[FIG. 11] FIG. 11 is a back view (plan view seen from behind) of the lid.
[FIG. 12] FIG. 12 is a back view of the protector.
[FIG. 13] FIG. 13 is a side view of the protector.
[FIG. 14] FIG. 14 is a perspective view of a main section illustrating an attachment structure of the protector (baffle plate).
[FIG. 15] FIG. 15 is a schematic view illustrating behavior of the powertrain (inverter) and a brake booster during a vehicle frontal collision.
[FIG. 16] FIG. 16 is a perspective view of the inverter (in a state of including the protector) according to a second embodiment.
[FIG. 17] FIG. 17 is a back view of the inverter.
[FIG. 18] FIG. 18 is a side view of a main section of the inverter.
[FIG. 19] FIG. 19 is a perspective view of the inverter in a state where the protector is detached.
[FIG. 20] FIG. 20 is a perspective view of the protector.

### [Description of Embodiments]

A detailed description will be made on an embodiment of the invention with reference to the drawings. The present embodiment exemplifies the invention, and the invention is not limited to the following embodiment in any respect except for an essential configuration thereof.

### [Configuration of Vehicle V]

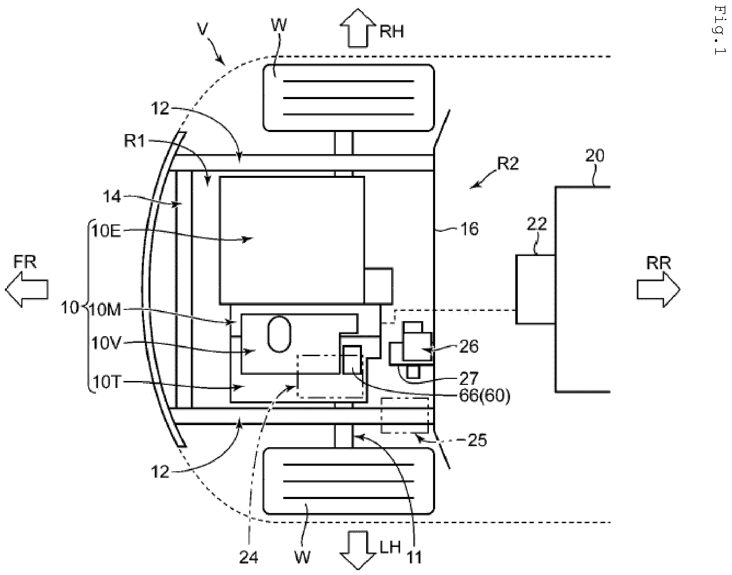

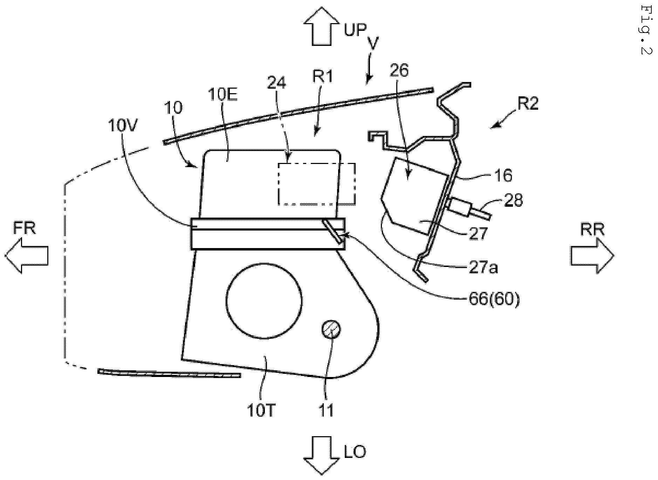

FIG. 1 is a plan view illustrating a schematic configuration of a vehicle V that includes an in-vehicle device according to the invention, and FIG. 2 is a cross-sectional view illustrating the schematic configuration of the vehicle V. In the drawings used in the following description, "FR" indicates a vehicle front direction, "RR" indicates a vehicle rear direction, "LH" indicates a vehicle left direction, "RH" indicates a vehicle right direction, "UP" indicates a vehicle up direction, and "LO" indicates a vehicle down direction. In addition, unless otherwise specifically described, a "front-rear direction" refers to a front-rear direction of the vehicle V.

The vehicle V illustrated in FIG. 1 may be a hybrid electric vehicle (HEV) that has an engine 10E and a motor 10M as drive sources for travel (that is, drive sources of wheels W). However, the vehicle according to the invention is not limited to the hybrid electric vehicle, and may be an electric vehicle (EV) .

The vehicle V includes a powertrain 10 that includes the engine 10E, the motor generator 10M, a transaxle 10T, an inverter 10V, and the like. The powertrain 10 is arranged in a compartment R1 (also referred to as a powertrain room) that is provided in a front portion of the vehicle V. More specifically, in plan view, the powertrain 10 may be arranged in a space that is surrounded by a pair of left and right front side frames 12 extending in the vehicle front-rear direction, a front cross member 14 coupling front end portions of both of the front side frames 12 in a vehicle width direction, and a dashboard 16. The dashboard 16 is a partition wall that separates the compartment R1 and a cabin R2.

The motor generator 10M (hereinafter referred to as the motor 10M) may be a three-phase three-wire AC motor that rotates when being supplied with three-phase AC power, and may include: an output shaft coupled to the engine 10E via an electromagnetic clutch, which is not illustrated, a rotor having a permanent magnet disposed around the output shaft, and a stator core disposed on an outer periphery of the rotor and in which a coil is wound around each of plural teeth. The plural coils may include a U-phase coil, a V-phase coil, and a W-phase coil, and currents in mutually different phases are supplied to the coils of the respective phases.

The transaxle 10T may be connected to the motor 10M, and may include: a transmission that decelerates rotation input from the motor 10M; and a differential gear that further distributes the rotation decelerated by the transmission into the left and right wheels W. A rotational driving force generated by the engine 10E or the motor 10M is output from the differential gear to a driveshaft 11 and is transmitted to the wheels W.

The vehicle V can be a parallel hybrid electric vehicle, for example, and can be capable of traveling only by the driving force of the motor 10M, traveling by the driving forces of both of the motor 10M and the engine 10E, and traveling only by the driving force of the engine 10E by turning on/off of the electromagnetic clutch. During the deceleration of the vehicle V, the motor 10M can generate electric power by rotational forces of the wheels W.

A battery 20 may be arranged under a floor of the cabin R2 that is located behind and separated from the compartment R1 with the dashboard 16 being interposed therebetween. The battery 20 exchanges the electric power with the motor 10M. When the motor 10M functions as a drive source for travel, the battery 20 may supply the electric power to the motor 10M. In this case, DC power is supplied to the battery 20 via a DC/DC converter 22 that is provided in a power supply path between the battery 20 and the motor 10M. Meanwhile, when the motor M functions as the generator during the deceleration of the vehicle V, the battery 20 may store the electric power generated by the motor 10M.

The inverter 10V can be arranged on top of the motor 10M and the transaxle 10T, and is connected to the motor 10M. The inverter 10V is a power converter that can convert the DC power from the battery 20 into the AC power and can supply the AC power to the motor 10M. More specifically, the inverter 10V can convert the DC power, which is supplied from the battery 20 via a DC circuit including the DC/DC converter 22, into three-phase AC power, and can supply the three-phase AC power to the motor 10M.

When the motor 10M functions as the generator during the deceleration of the vehicle V, the inverter 10V can convert the AC power (regenerative power), which is generated by the motor 10M, into the DC power, and can supply the DC power to the battery 20 via the DC circuit including the DC/DC converter 22.

Although indicated by imaginary lines in FIGs. 1 and 2 for convenience of description, the vehicle V can also include a battery 24 for supplying the electric power to an electrical component and the like provided in each portion of the vehicle V, in addition to the battery 20 for the power supply to the motor 10M. That is, the vehicle V can include the auxiliary battery 24 in addition to the travel battery 20 that supplies the electric power for travel. The auxiliary battery 24 can have a lower nominal voltage than the travel battery 20.

For example, the travel battery 20 can be a lithium-ion battery or a nickel-metal hydride battery, a nominal voltage of which is 24 V or higher, and the auxiliary battery 24 can be a lead battery or a lithium-ion battery, a nominal voltage of which is 12 V.

The auxiliary battery 24 can be arranged above the inverter 10V. More specifically, in the plan view, the battery 24 may be arranged at a position to cover an attachment portion (protector attachment portion 47) of a protector 60, which will be described below, in the inverter 10V from above. That is, the battery 24 can be provided to block an access path to the protector attachment portion 47.

In the compartment R1, a brake booster 26 can be arranged behind the powertrain 10, more specifically, behind the inverter 10V. The brake booster 26 is an example of an auxiliary machine that can be arranged behind the inverter 10V in the compartment R1. As illustrated in FIG. 2, a lower portion of the brake booster 26 can be located at substantially the same height as the inverter 10V. That is, the brake booster 26 can be arranged at a position at which the lower portion thereof overlaps the inverter 10V when seen in the front-rear direction.

The brake booster 26 is a booster that amplifies a brake pedal operation force (depression force) by an occupant and transmits the amplified force to a brake unit (master cylinder). The brake booster 26 may include a booster body 27 and an input portion 28 for inputting the depression force by the occupant to the booster body 27.

The booster body 27 can be fixed to a front surface (a side surface on the compartment R1 side) of the dashboard 16 via a bracket, and the input portion 28 may protrude to a leg area below a driver's seat in the cabin R2 through an opening formed in the dashboard 16. The brake pedal, which is not illustrated, can be coupled to this input portion 28.

A powertrain control module (PCM) 25 can be further mounted on the vehicle V. The PCM 25 is a controller that comprehensively controls the powertrain 10 including the motor 10M and the engine 10E.

### [Arrangement of Inverter 10V]

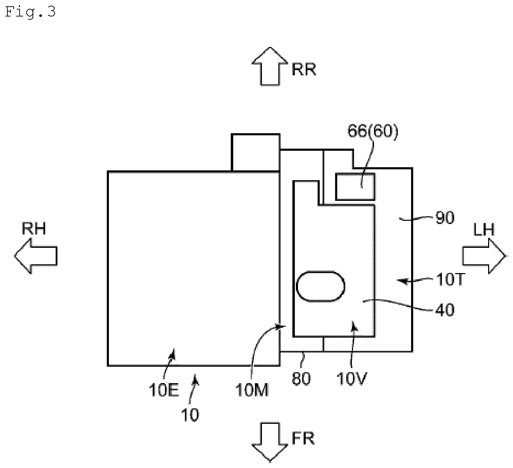

FIG. 3 is a plan view of the powertrain 10 that includes the inverter 10V. As illustrated in FIG. 3, the powertrain 10 may include the engine 10E, the motor 10M, and, optionally the transaxle 10T in an order from the right side of the vehicle.

The engine 10E may be a multi-cylinder reciprocating engine, for example, and may be arranged in a so-called horizontal posture in which a crankshaft extends in the vehicle width direction. The motor 10M may be arranged on a left side adjacent to a cylinder block of this engine 10E. The motor 10M can have a motor housing 80 that constitutes an outer shell thereof. The motor housing 80 can be joined to the cylinder block, and the motor 10M is thereby assembled to the engine 10E.

The transaxle 10T may have a transaxle housing 90 that constitutes an outer shell thereof. This transaxle housing 90 may be joined to the motor housing 80, and the transaxle 10T is thereby assembled to the motor 10M.

The motor housing 80 and the transaxle housing 90 may each be made of a highly rigid metallic material such as aluminum die casting or a highly rigid resin material such as carbon fiber reinforced resin. Accordingly, the motor 10M and the transaxle 10T are highly rigid drive systems using the motor 10M as a drive source.

The inverter 10V may be arranged at a position that is on top of the powertrain 10 and extends across the motor 10M and the transaxle 10T. In particular, the inverter 10V as part of the powertrain 10 may be above the motor 10M and the transaxle 10T in the vehicle up direction ("UP").

The inverter 10V may have an inverter housing 40 that constitutes an outer shell thereof. The inverter housing 40 can be made of the resin material such as the metallic material or the carbon fiber reinforced resin. This inverter housing 40 may be joined to an upper portion of the motor housing 80 and an upper portion of the transaxle housing 90, and the inverter 10V is thereby integrally assembled to both of the motor 10M and the transaxle 10T. That is, the inverter 10V may be fixed to an upper portion of the highly rigid drive system.

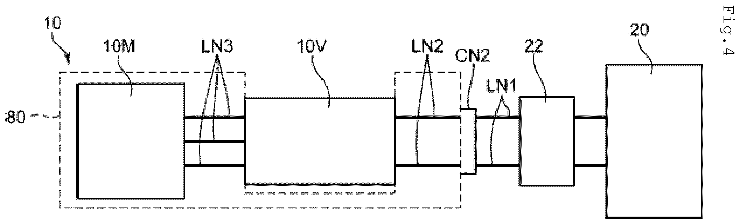

FIG. 4 is a view illustrating electrical connection between the battery 20 and the powertrain 10. The battery 20 may be connected to the powertrain 10 via the DC/DC converter 22. The DC power from the battery 20 can be supplied to the inverter 10V via the DC/DC converter 22, is converted into the AC power, and is supplied to the motor M. During the deceleration of the vehicle V, the AC power that is generated by the motor 10M is converted into the DC power by the inverter 10V, and is then supplied to the battery 20 via the DC/DC converter 22.

The inverter 10V and the DC/DC converter 22 can be connected to each other via a DC wire LN1, which is a wire harness routed in a vehicle body, and a DC wire LN2, which is routed in the motor housing 80. The DC wire LN1 and the DC wire LN2 can be coupled to each other by a connector CN2 that is provided in a rear portion of the motor housing 80. In the DC wire LN2, a predetermined range including at least an end portion on the inverter 10V side can be configured with a bus bar. The bus bar can be fastened to a terminal block 33 of a DC input/output unit 32, which will be described below, (corresponding to the "electrical connection portion") in the inverter 10V, and the DC wire LN2 is thereby connected to the inverter 10V.

The motor 10M and the inverter 10V may be connected by an AC wire LN3. In the AC wire LN3, a predetermined range including at least an end portion on the inverter 10V side can be configured with a bus bar. The bus bar can be fastened to a terminal block of an AC input/output unit 38, which will be described below, in the inverter 10V, and the AC wire LN3 is thereby connected to the motor 10M.

### [Configuration of Inverter 10V (First Embodiment)]

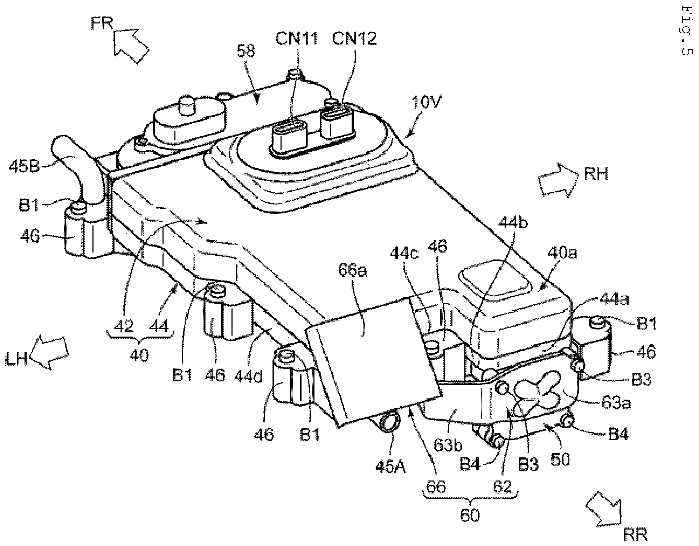

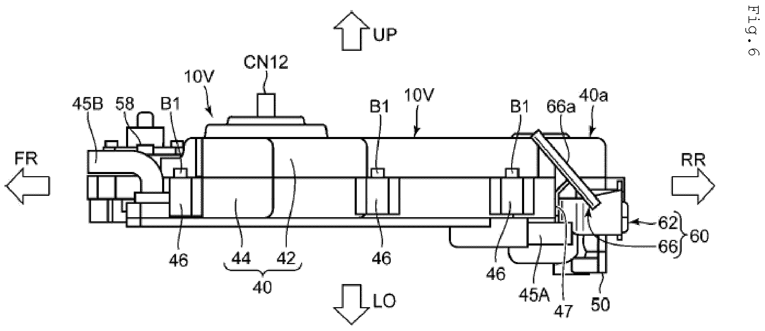

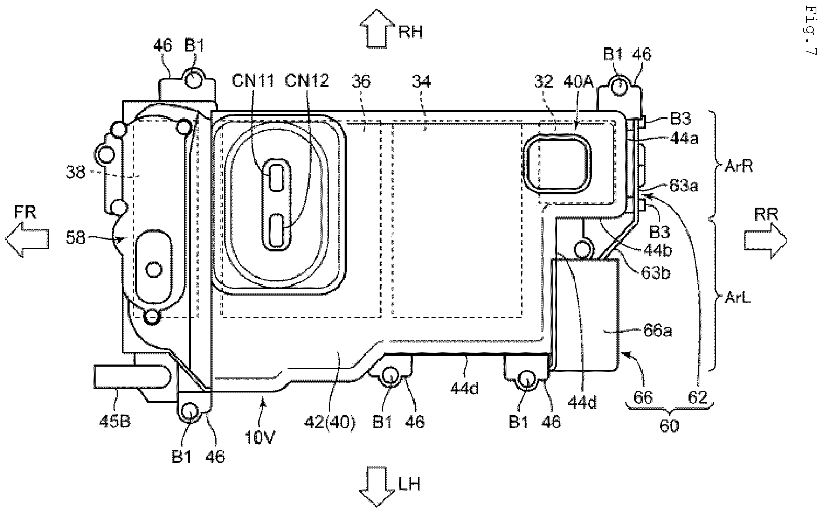

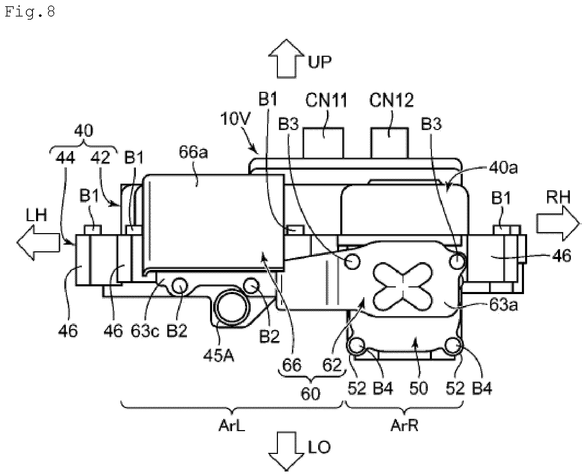

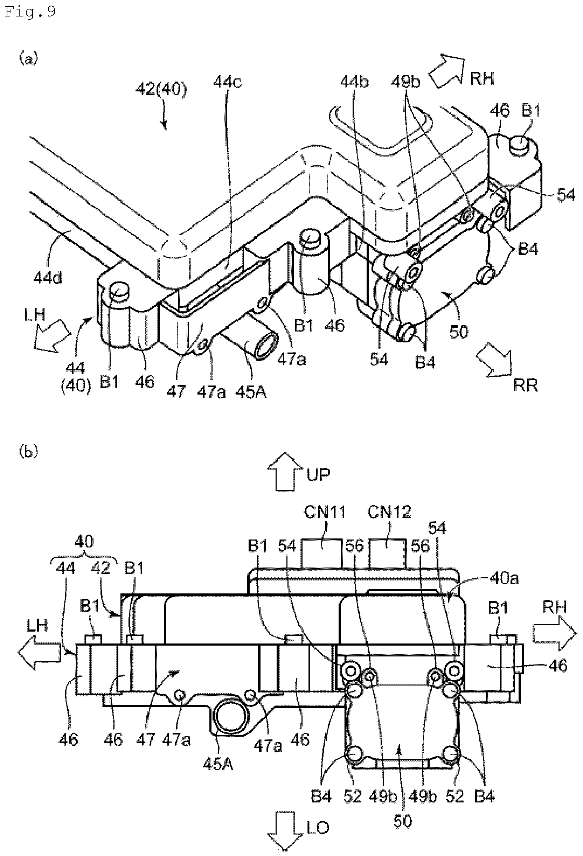

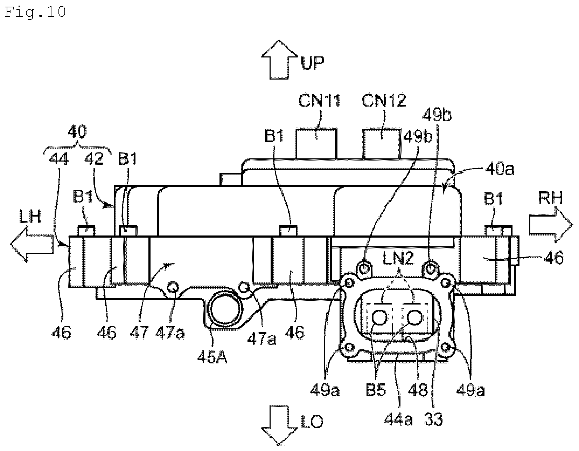

FIGs. 5 to 8 are views illustrating the inverter 10V in a state where the protector 60, which will be described below, is attached, FIG. 5 is a perspective view of the inverter 10V, FIG. 6 is a side view (side view seen from the left side) of the inverter 10V, FIG. 7 is a plan view of the inverter 10V, and FIG. 8 is a back view of the inverter 10V. FIG. 9 includes views of the inverter 10V in a state where the protector 60 is detached, in which FIG. 9A is a perspective view of the inverter 10V, and FIG. 9B is a back view of the inverter 10V. FIG. 10 is a back view of the inverter 10V in a state where a lid 50 for an opening 48, which will be described below, is detached. The inverter 10V and the protector 60, which will be described below, are part of the "in-vehicle device" according to the invention.

As illustrated in FIGs. 5 to 8, the inverter 10V may have the inverter housing 40 that may be elongated in the front-rear direction and that may have a substantially rectangular shape in a plan view, and may have a configuration that the protector 60 is attached to a rear end portion of this inverter housing 40.

The inverter housing 40 may include: a dish-shaped upper housing 42 that has an upper surface portion and a peripheral wall portion extending downward from a peripheral edge of the upper surface portion; and a dish-shaped lower housing 44 that has a bottom surface portion and a peripheral wall portion extending upward from a periphery of the bottom surface portion. The upper housing 42 and the lower housing 44 may be assembled to each other in the up-down direction, and thereby constitute the inverter housing 40. As described above, the inverter housing 40 may be formed of the metallic material or the resin material such as the carbon fiber reinforced resin.

The inverter housing 40 (hereinafter, may also be simply referred to as the housing 40) may include plural fastening portions 46 that are formed on a peripheral wall portion thereof, more specifically, the peripheral wall portion of the lower housing 44. Each of the fastening portions 46 may be a portion that is formed to be thicker than the rest of the peripheral wall portion of the lower housing 44. When a bolt B1 is screwed into a screw hole formed in each of the motor housing 80 and the transaxle housing 90 via a through hole formed in the respective fastening portion 46, the inverter 10V may be fixed (fastened) onto the top of the motor 10M and the transaxle 10T.

The upper housing 42 may be provided with plural PCM connectors CN11, CN12, each of which protrudes upward. Each of the PCM connectors CN1, CN12 may be a connector for connecting the PCM 25 to the inverter 10V by electrical wiring.

As illustrated in FIG. 7, the inverter 10V may include a DC input/output unit 32, a smoothing unit 34, a power module unit 36, and the AC input/output unit 38 that are accommodated in the housing 40. The DC input/output unit 32, the smoothing unit 34, the power module unit 36, and the AC input/output unit 38 may be disposed in this order from the rear side to the front side of the vehicle V.

An opening, which is not illustrated, may be provided in a lower surface of a front end portion of the lower housing 44. Through this opening, the AC wire LN3, which includes the bus bar, may be inserted in the housing 40 and fastened to the terminal block of the AC input/output unit 38 by a bolt. By this fastening, the AC wire LN3 may be connected to the inverter 10V. In FIG. 5, a lid 58 closes the opening that leads to a connection portion between the AC input/output unit 38 and the AC wire LN3, and may be fixed to the upper housing 42.

As illustrated in FIG. 7, in the plan view of the inverter 10V, a partial area (referred to as a right area ArR) at a right end of a rear end portion of the housing 40 may protrude rearward from the rest of the area (referred to as a left area ArL) of the rear end portion of the housing 40. The DC input/output unit 32 may be accommodated in this protruding portion 40a. An opening, which is not illustrated, may be provided on a lower surface of the protruding portion 40a, that is, the lower surface of a portion, which corresponds to the protruding portion 40a, in the lower housing 44. Through this opening, the DC wire LN2, which includes the bus bar, may be inserted in the protruding portion 40a.

The DC wire LN2 may penetrate an upper wall portion of the motor housing 80, may be inserted in the protruding portion 40a through the opening, which is not illustrated, and may be fixed (fastened) to the terminal block 33 of the DC input/output unit 32 by a bolt B5 (see FIG. 10). By this fastening, the DC wire LN2 is connected to the inverter 10V.

A horizontally long oval-shaped opening 48 may be provided in a rear wall 44a of the lower housing 44 in the protruding portion 40a. The opening 48 may be a service hole for access to the terminal block 33, that is, an electrical connection portion between the DC input/output unit 32, which is provided in the inverter 10V, and the DC wire LN2 (hereinafter, may also be referred to as a service hole 48). The service hole 48 may be opened rearward and may thus constitute a path accessible to the terminal block 33 in the front-rear direction. That is, by inserting a tool through the service hole 48 from behind, the bolt B5 of the terminal block 33 can be attached/detached.

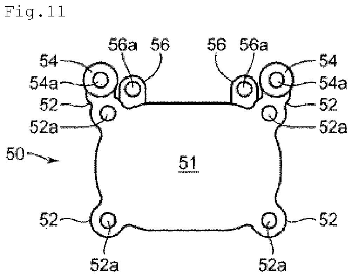

As illustrated in FIG. 9, the service hole 48 is closed by the plate-shaped lid 50 (lid member). FIG. 11 is a back view (plan view seen from behind) illustrating the lid 50 alone.

The lid 50 may be formed of an insulating material such as a resin. As illustrated in FIG. 11, the lid 50 may include: a substantially-rectangular lid body portion 51 that closes the service hole 48; four fixing protruding pieces 52, each of which extends outward from the lid body portion 51; and two temporary fixing protruding pieces 56. The fixing protruding pieces 52 are portions for fixing the lid 50 to the housing 40 (lower housing 44) and may be provided at four corners of the lid body portion 51. Meanwhile, the temporary fixing protruding pieces 56 may be portions for temporarily fixing (temporarily placing) the lid 50 to the housing 40 before fixation of the lid 50. Between the two upper fixing protruding pieces 52, each of the temporary fixing protruding pieces 56 may be provided adjacent to the respective fixing protruding piece 52.

As illustrated in FIG. 10, four screw holes 49a that correspond to the fixing protruding pieces 52, and paired temporary fixing pins 49b that correspond to temporary fixing protruding pieces 56 may be provided in a portion of the rear wall 44a around the service hole 48. The paired temporary fixing pins 49b may protrude rearward in parallel with each other from the rear wall 44a, and may extend in an attachment/detachment direction of the lid 50, that is, the front-rear direction. In this example, the paired temporary fixing pins 49b each correspond to the "temporary placement portion".

As illustrated in FIGs. 9 and 10, the temporary fixing pins 49b may be inserted in pin holes 56a that may be provided to the temporary fixing protruding pieces 56. In such a state, bolts B4 may be screwed into the screw holes 49a via through holes 52a that are provided to the fixing protruding pieces 52, and the lid 50 may thereby be fixed (fastened) to the rear wall 44a.

When the lid 50 is attached, the temporary fixing pins 49b may be inserted in the pin holes 56a of the temporary fixing protruding pieces 56. In this way, prior to fastening by the bolts b4, the lid 50 can be temporarily fixed (temporarily placed) to the protruding portion 40a. This contributes to improvement in assemblability of the inverter 10V.

The temporary fixing pins 49b and the pin holes 56a may be provided such that, when the lid 50 is moved along the paired temporary fixing pins 49b in the front-rear direction substantially without inclination, the lid 50 can be attached/detached to/from the temporary fixing pins 49b.

Of the four fixing protruding pieces 52, the two upper fixing protruding pieces 52 may have a different configuration from the other (22 lower) fixing protruding pieces 52. That is, as illustrated in FIG. 11, the two upper fixing protruding pieces 52 may each be provided with an extending portion that extends further outward from a position of the respective through hole 52a, and boss portions 54 may each be provided at an end of the respective extending portion.

Each of the boss portions 54 may be a portion to which the protector 60, which will be described below, is attached. The boss portions 54 each protrude rearward from a rear surface of the respective fixing protruding piece 52, and a screw hole 54a for fixing the protector may be provided in the respective fixing protruding piece 52.

In each of the fixing protruding pieces 52, an area on the boss portion 54 side from the through hole 52a may be configured to have lower rigidity than the rest of the portions. More specifically, a part of the extending portion includes a fragile portion that may be formed to be thinner than the other portion or in which the extending portion is notched. In this way, the area the boss portion 54 side from the through hole 52a is configured to have the low rigidity. With this configuration, when a load that is equal to or larger than a specified value is input to the protector 60 fixed to the boss portion 54, the portion including the boss portion 54 in the fixing protruding piece 52 is deformed or split from another portion. As a result, breakage of the lid body portion 51 is prevented.

The protector 60 may be attached to the rear end portion of the housing 40. The protector 60 is a member that protects the inverter 10V and suppresses rearward movement of the brake booster 26 during interference (a collision) between the inverter 10V and the brake booster 26. The protector 60 also has a function of preventing a person from accessing the terminal block 33 of the DC input/output unit 32 carelessly.

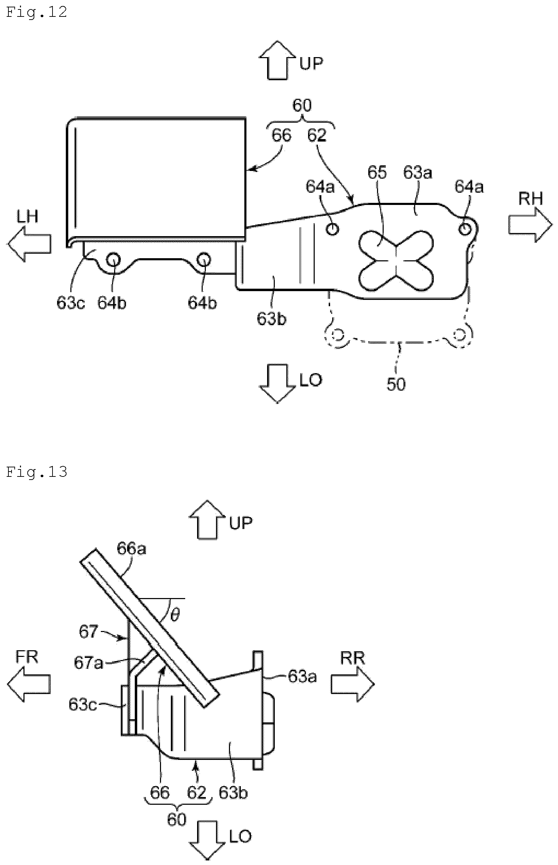

FIGS. 12 and 13 each illustrate the protector 60 alone, FIG. 12 is a back view (plan view when seen from behind) of the protector 60, and FIG. 13 is a side view (left view) of the protector 60.

As illustrated in FIGs. 5 to 8, 12, and 13, the protector 60 may include a baffle plate 62 and a guide portion 66. The guide portion 66 has a function of guiding the brake booster 26 upward in order to suppress the rearward movement of the brake booster 26 during a vehicle frontal collision. The guide portion 66 corresponds to the "interference portion" and the "priority interference portion".

The guide portion 66 may be a rectangular member that is made of a metal plate, and may have a front-upward inclined surface 66a that faces rearward and obliquely upward. The inclined surface 66a may be a guide surface that guides the brake booster 26 upward during a collision with the brake booster 26. The inclined surface 66a is a flat surface. In this example, an inclination angle θ thereof with respect to a horizontal plane is set to 45°, for example. The guide portion 66 may be joined to a fixed portion 63c, which will be described below, in the baffle plate 62 via a leg 67.

The baffle plate (baffle) 62 may be formed of a metal plate and may extend along a rear end surface of the housing 40 from a right end to a left end thereof. The baffle plate 62 may include a cover portion 63a, a coupling portion 63b, and the fixed portion 63c in this order from the right side in the vehicle width direction.

The cover portion 63a may be a portion that opposes the lid 50 from behind and thereby covers a part of the lid 50. The fixed portion 63c may be a portion that opposes a rear wall 44c of the lower housing 44 from behind in the left area ArL (see FIG. 7) of the housing 40. The fixed portion 63c may be arranged ahead of the cover portion 63a. The coupling portion 63b may be a portion between the cover portion 63a and the fixed portion 63c, and extends obliquely forward from a left end of the cover portion 63a and is connected to a right end of the fixed portion 63c in a plan view. That is, the protector 60 may have a substantially crank-like shape in the plan view.

As described above, the guide portion 66 may be joined to the fixed portion 63c of the baffle plate 62 via the leg 67. The leg 67 may be a pressed member that is made of a metal plate and has a three-dimensional shape. As illustrated in FIG. 13, the leg 67 may be configured to include a plate-shaped support portion 67a that extends forward and obliquely downward from the guide portion 66 along a direction (substantially normal direction) perpendicular to a plane of the inclined surface 66a in a side view.

The leg 67 may be joined to each of a rear surface of the fixed portion 63c of the baffle plate 62 and a lower surface (surface opposite to the inclined surface 66a) of the guide portion 66 by welding. As a result, the guide portion 66 and the baffle plate 62 may be integrally formed. Here, the leg 67 may be integrally formed with the fixed portion 63c of the baffle plate 62 by pressing.

In a state where the protector 60 is fixed to the housing 40, as illustrated in FIGs. 5 to 7, the guide portion 66 may be arranged on the left side of the protruding portion 40a of the housing 40, that is, in the left area ArL. A rear end portion of the guide portion 66 may be located substantially at the same position as a rear end portion of the protruding portion 40a, and an upper end portion of the guide portion 66 may be located substantially at the same position as an upper end portion of the protruding portion 40a.

As illustrated in FIG. 1, the guide portion 66 arranged accordingly may be located ahead of the booster body 27 of the brake booster 26 in the plan view. In addition, as illustrated in FIG. 2, the guide portion 66 may be located at a height that is equal to a lower portion of the booster body 27, more specifically, an inclined surface 27a, which will be described below, of the booster body 27.

As illustrated in FIGs. 5 to 9, the protector 60 is fixed to the protector attachment portion 47 (corresponds to the "first protector attachment portion") that is provided in the left area ArL of the housing 40.

The protector attachment portion 47 may be provided to the rear wall 44c of the lower housing 44 in the left area ArL with a clearance being interposed therebetween. More specifically, as illustrated in FIGs. 9A and 9B, the fastening portions 46 may each be provided in a rear end portion of a side wall 44d at a left end of the lower housing 44 and a right end of the rear wall 44c of the lower housing 44 in the left area ArL, more precisely, a corner portion between the rear wall 44c and a side wall 44b of the lower housing 44 in the protruding portion 40a. As described above, each of the fastening portions 46 may be the portion that is formed to be thicker than the rest of the peripheral wall portion of the lower housing 44.

The protector attachment portion 47 may be provided in a bridge shape so as to straddle the two fastening portions 46. Then, bolts B2 may be screwed into paired screw holes 47a, which are formed in the protector attachment portion 47, through paired through holes 64b formed in the fixed portion 63c of the baffle plate 62. As a result, the protector 60 may be fixed to the protector attachment portion 47.

An inlet port 45A for a refrigerant (for example, a coolant) may be made of a pipe material and provided in a lower portion at the rear end of the lower housing 44 in the left area ArL, and a similar outlet port 45B may be provided in the front end portion of the lower housing 44 in the left area ArL. These ports 45A, 45B are respectively a refrigerant inlet and a refrigerant outlet, each of which communicates with a cooling passage provided in the housing 40. The refrigerant may be introduced into the housing 40 from the inlet port 45A, may flow through the housing 40 while meandering, and may be discharged from the outlet port 45B. Just as described, the refrigerant circulates in the housing 40, and thereby cools the power module unit 36 and the like.

The inlet port 45A may extend below the protector attachment portion 47 along the lower surface of the lower housing 44 and may then extend to the rear of the protector attachment portion 47. Each of lower side portions of the protector attachment portion 47 and the baffle plate 62 (fixed portion 63c), which is fixed to the protector attachment portion 47, may be formed to be recessed upward so as to avoid the inlet port 45A.

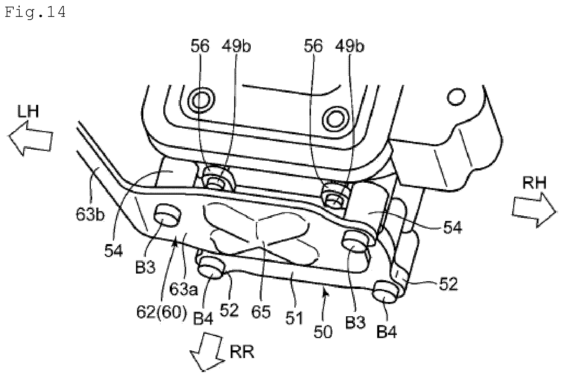

The protector 60 may be further fixed to the lid 50. More specifically, the cover portion 63a of the baffle plate 62 may be formed with through holes 64a that correspond to the boss portions 54 (each correspond to the "second protector attachment portion") of the lid 50. As illustrated in FIGs. 8 and 14, bolts B3 may be screwed into the screw holes 54a of the boss portions 54 through the through holes 64a. In this way, the cover portion 63a may be fixed to the lid 50. FIG. 14 is a perspective view of a main section of the inverter 10V illustrating an attachment structure of the protector 60 (cover portion 63a of the baffle plate 62).

In a state where the cover portion 63a is fixed to the lid 50, the cover portion 63a may oppose the lid 50 from behind. More specifically, as illustrated in FIGs. 5 and 8, the cover portion 63a may cover a substantially upper half portion of the lid 50 from behind and thereby hides the two upper bolts B4 that fix the lid 50.

### [Behavior of Powertrain 10 and Brake Booster 26 During Vehicle Frontal Collision]

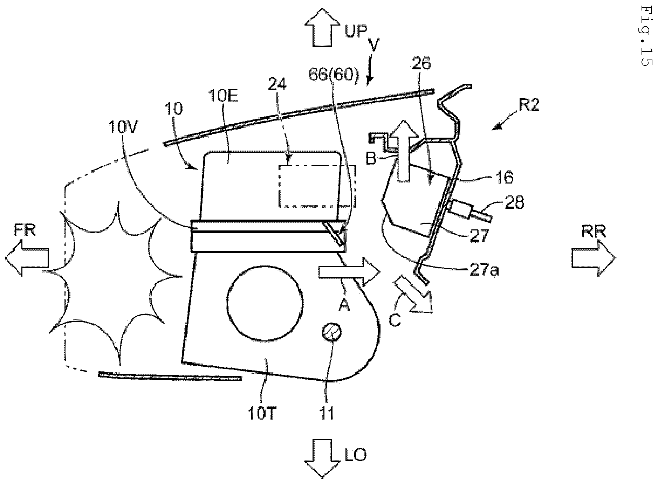

FIG. 15 is a schematic view illustrating behavior of the powertrain 10 (inverter 10V) and the brake booster 26 during the vehicle frontal collision.

When the frontal collision occurs to the vehicle V, the inverter 10V may move rearward together with the powertrain 10 (an arrow A), and the inverter 10V collides (interferes) with the rear brake booster 26 via the protector 60. More specifically, first, the inverter 10V may collide with the brake booster 26 via the inclined surface 66a of the guide portion 66. The inclined surface 66a of the guide portion 66 may be the front-upward inclined surface. Thus, when the guide portion 66 collides with the brake booster 26, the brake booster 26 is displaced upward (an arrow B), and the powertrain 10 is displaced downward (an arrow C). In this case, when the inclined surface 27a at the lower front end of the booster body 27 and the inclined surface 66a of the guide portion 66 abut each other, the powertrain 10 and the brake booster 26 are displaced from each other along the inclined surfaces 27a, 66a.

As a result of the upward displacement of the brake booster 26, the brake booster 26 is prevented from moving rearward together with the dashboard 16 and entering the cabin R2.

### [Effects]

In the above-described vehicle V1, the terminal block 33 in the inverter 10V is the electrical connection portion that may be connected to the high-voltage DC wire LN2, and there is a risk of electric shock when the lid 50 is removed carelessly and the terminal block 33 is touched. Since the configuration as described above is adopted for the inverter 10V and the protector 60, it is possible to effectively suppress careless access to the terminal block 33 with the simple configuration using the protector 60. That is, in the present embodiment, the lid 50 is covered with the protector 60 that is attached to the inverter 10V, more specifically, the lid 50 may be covered with the cover portion 63a of the protector 60 from behind. Thus, the protector 60 has to be detached in order to detach the lid 50. The need for detachment of the protector 60, just as described, serves as a deterrent against easy detachment of the lid 50. As a result, it is possible to suppress the careless access to the terminal block 33 with the simple configuration using the protector 60.

In this example embodiment of the attachment of the protector 60, the cover portion 63a (protector 60) may be provided to block the access path to the bolt B4 by covering the bolt B4 for fixing the lid 50 from behind, more specifically, by covering some (two upper bolts B4) of the four upper and lower bolts B4 from behind. Thus, it is possible to suppress the careless access to the terminal block 33 with the further simple configuration without covering the entire lid 50 with the cover portion 63a.

In another embodiment according to the present invention, the protector 60 may be fixed to the inverter 10V at the two points. More specifically, the fixed portion 63c may be fixed to the protector attachment portion 47, and the cover portion 63a may be fixed respectively to the lid 50. Accordingly, in order to detach the protector 60, since it is required to perform detachment for both of the protector attachment portion 47 and the lid 50, it takes time and effort as compared with a case where the protector 60 is fixed at any one position. By increasing the time and effort to detach the protector 60, just as described above, the deterrent against detachment action of the lid 50 is improved. Thus, it is possible to further highly suppress the careless access to the terminal block 33.

In addition, according to another embodiment of the present disclosure, the point at which the cover portion 63a is fixed may be a different point from the point at which the lid 50 is fixed. That is, while the lid 50 may be fixed to the housing 40 by the bolts B4 through the through holes 52a of the fixing protruding pieces 52, the cover portion 63a may be fixed to the boss portions 54, each of which is provided in the respective fixing protruding piece 52, by the bolts B3, and the lid 50 and the fixed portion 63c may not be fastened together but fastened separately. Thus, in order to access the terminal block 33, it is required to detach the protector 60 from both of the protector attachment portion 47 and the lid 50 (boss portions 54) and then to remove the lid 50 fixed to the housing 40. That is, since detachment work is required for three places, the deterrent against detachment action of the lid 50 is further improved.

In the lid 50, each of the boss portions 54 (the area on the boss portion 54 side of the through hole 52a), to which the cover portion 63a (protector 60) is fixed, may be configured to have the lower rigidity than the other portion as described above. Accordingly, there is an advantage that the substantial damage to the lid 50 and thus the damage to the terminal block 33 can be avoided. That is, when the protector 60 and peripheral equipment collide with each other during the collision of the vehicle V, collision energy is absorbed by deformation of the boss portion 54 or split of the protector 60 from another portion. As a result, the breakage of the lid body portion 51 can be suppressed. Thus, in the case where the inverter 10V collides with the brake booster 26 via the protector 60 during the vehicle frontal collision, it is possible to effectively suppress the substantial breakage of the lid 50 and thus the damage to the terminal block 33.

As described above, in the case where the inverter 10V collides with the brake booster 26 via the protector 60 during the vehicle frontal collision as described above, the guide portion 66 of the protector 60 may collide (interferes) with the brake booster 26 immediately (preferentially). In the present embodiment, the terminal block 33 as the electrical connection portion of the inverter 10V may be arranged at a position that is located on the left side of and away from the guide portion 66 that preferentially collides with the brake booster 26, just as described. Thus, even when the inverter 10V collides with the brake booster 26 via the protector 60, the terminal block 33 is less likely to be damaged, and it is possible to effectively avoid power leakage and the like caused by the damage to the terminal block 33.

As illustrated in FIGs. 5 to 7, in the protector 60, a fixed portion (fixed portion 63c) to the protector attachment portion 47 may be offset forward from the lid 50 and the cover portion 63a. In addition, the fixed portion 63c may be hidden under the guide portion 66. That is, visual recognition of the fixed portion 63c is difficult in a rear view, and the visual recognition thereof is also difficult in the plan view. Thus, it is not easy to insert a tool or the like into the fixed portion 63c. Accordingly, it is difficult to detach the protector 60, and it is also possible to suppress the careless access to the terminal block 33 in this respect.

The paired temporary fixing pins 49b may be provided around the service hole 48 in the housing 40, and the lid 50 may be fixed in a state of being temporarily fixed (temporarily placed) to the temporary fixing pins 49b. More specifically, in the state where the temporary fixing pins 49b are inserted in the pin holes 56a provided in the temporary fixing protruding pieces 56, the lid 50 may be fixed to the housing 40 (rear wall 44a) by the bolts B4. In this configuration, in order to detach the lid 50, the lid 50 has to be displaced along the paired temporary fixing pins 49b and pulled away from the temporary fixing pins 49b. Thus, when the lid 50 is inclined or the like, the lid 50 cannot be pulled away from the temporary fixing pins 49b, which makes it difficult to detach the lid 50. That is, even when the bolts B4 are unscrewed, it is difficult to immediately detach the lid 50. Thus, it is also possible to suppress the careless access to the terminal block 33 in this respect.

### [Inverter 10V According To Second Embodiment]

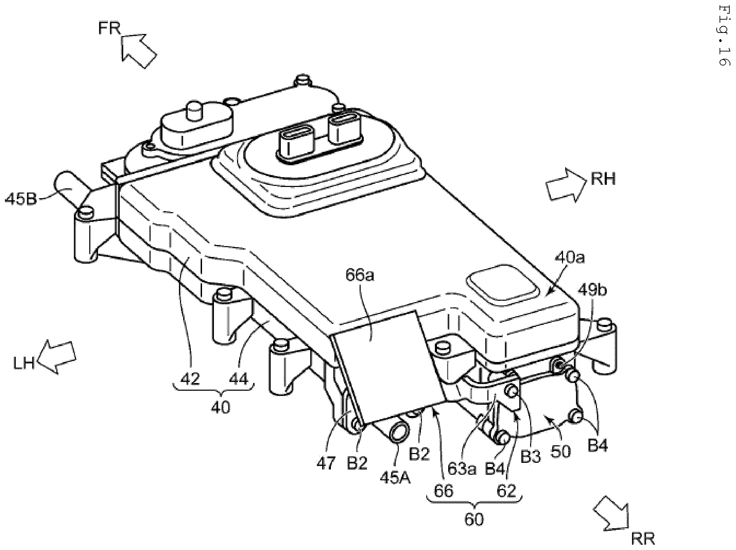

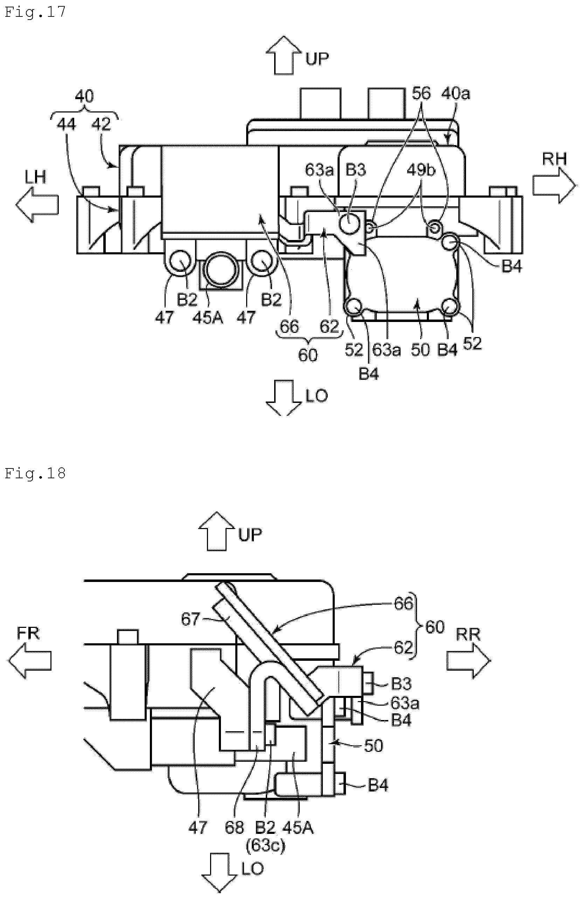

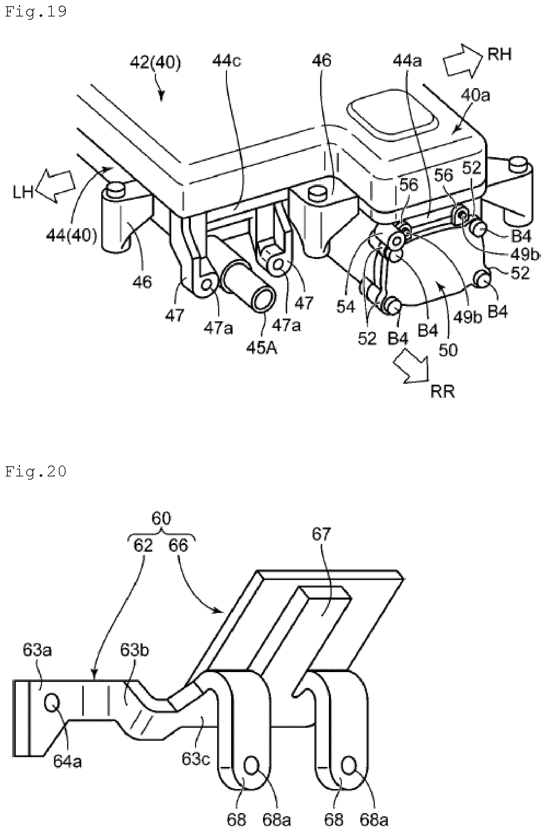

FIGs. 16 to 21 each illustrate the inverter 10V (the state where the protector 60 is attached) according to another embodiment. FIG. 16 is a perspective view of the inverter 10V, FIG. 17 is a back view of the inverter 10V, and FIG. 18 is a side view of a main section of the inverter 10V. FIG. 19 is a perspective view of the inverter 10V in the state where the protector 60 is detached, and FIG. 20 is a perspective view of the protector 60 alone.

The inverter 10V according to a second embodiment differs from the first embodiment mainly in the configurations of the protector 60 and the protector attachment portion 47.

As illustrated in FIGs. 16 to 18 and 20, the protector 60 may have the baffle plate 62 that includes the cover portion 63a, the coupling portion 63b, and the fixed portion 63c, and is common to that in the first embodiment in this respect. However, in the second embodiment, the cover portion 63a may be provided to oppose one fixing protruding piece 52 of the four fixing protruding pieces 52 in the lid 50 from behind. More specifically, the cover portion 63a may only oppose the upper left fixing protruding piece 52 and cover the bolt B4 for fixing the respective fixing protruding piece 52 from behind. Then, the cover portion 63a may be fixed to the boss portion 54 of the upper left fixing protruding piece 52 with the bolt B3.

As illustrated in FIGs. 18 and 20, the fixed portion 63c may include: paired belt-shaped fixed pieces 68, each of which is curved in an inverted U shape; and a belt-shaped support piece 69 that extends upward between the paired fixed pieces 68. The guide portion 66 may be joined to root portions of the fixed pieces 68 and the support piece 69 by welding or the like.

As described above, in the baffle plate 62, the cover portion 63a may be fixed to the boss portion 54 of the lid 50. Meanwhile, the fixed portion 63c may be fixed to the protector attachment portions 47 of the lower housing 44 via the fixed pieces 68. As illustrated in FIG. 19, the protector attachment portions 47 in the second embodiment may be formed as protruding pieces that hang down on both of the left and right sides of the refrigerant inlet port 45A. The fixed pieces 68 may be respectively fixed to these protector attachment portions 47 via the bolts B2. Thus, in the first embodiment regarding the configuration of the inverter 10V, the fixed portion 63c may be fixed directly to the protector attachment portions 47, whereas in the second embodiment regarding the configuration of the inverter 10V, the fixed portion 63c may be fixed to the protector attachment portion 47 via the paired fixed pieces 68.

The inverter 10V in the second embodiment has the different configuration from that in the first embodiment as described above, but has the common basic configuration to that in the first embodiment. Thus, similar to the first embodiment, the inverter 10V in the second embodiment, precisely, the inverter 10V, to which the protector 60 is attached, can suppress the careless access to the terminal block 33 as the electrical connection portion with the simple configuration using the protector 60.

In particular, in the second embodiment, the cover portion 63a of the protector 60 may be formed to oppose one fixing protruding piece 52 of the four fixing protruding pieces 52 in the lid 50. Thus, it is possible to suppress the careless access to the terminal block 33 while suppressing a size of the cover portion 63a to a minimum required size.

Alternatively or additionally, in the second embodiment, the protector attachment portions 47 can be provided separately on both of the sides of the refrigerant inlet port 45A. Accordingly, the protector attachment portions 47 in the second embodiment may have such an advantage that a degree of freedom in the up-down direction of the inlet port 45A is higher than that for the protector attachment portion 47 in the first embodiment.

Furthermore, since each of the protector attachment portions 47 may be provided in the manner to hang downward from the lower housing 44, it is possible to transmit the collision load, which is input to the guide portion 66, to the bottom surface portion of the lower housing 44 having relatively high bearing strength. That is, since the bottom surface portion of the lower housing 44 extends in the front-rear direction, it is possible to effectively suppress the damage to the lower housing 44 by distributing the collision load while transmitting the collision load to the bottom surface portion.

### [Modified Examples]

The vehicle V that has been described so far are examples of the vehicle V that includes the in-vehicle devices (the inverter 10V and the protector 60) according to the present invention. However, the following configurations are possible:.
(1) In one embodiment, the cover portion 63a of the protector 60 may be fixed (fastened) to the boss portion 54 of the lid 50 by the bolt B3. However, the cover portion 63a may be fixed thereto by another fixing member such as a rivet or a clip.
(2) In the powertrain 10 , the inverter 10V may be fixed to the motor 10M and the transaxle 10T. However, it may be configured that the inverter 10V may be fixed only to the motor 10M.
(3) The protector 60 may be provided with the guide portion 66 that abuts the brake booster 26 and displaces the brake booster 26 upward during the vehicle frontal collision. However, the protector 60 may be configured not to include the guide portion 66, for example.
(4) The inverter 100 may be applied as an example of the power converter. However, a device other than the inverter can also be applied as the power converter. For example, a DC/DC converter may be adopted as the power converter.

### [Reference sign list]

10 powertrain
10E engine
10M motor
10T transaxle
10V inverter (power converter/in-vehicle device)
20 battery
26 peripheral equipment (brake booster)
32 DC input/output unit
33 terminal block (electrical connection portion)
47 protector attachment portion (first protector attachment portion)
48 opening
49b temporary placement portion
50 lid
51 lid body portion
52 fixing protrusion piece
54 boss portion (second protector attachment portion)
60 protector (in-vehicle device)
62 baffle plate
63a cover portion
63b coupling portion
63c fixed portion
66 guide portion (priority interference portion/ interference portion)
66a inclined surface (guide surface)
68 fixed pieces
69 support piece
B4 bolts (fixing member)
R1 compartment (powertrain room)
V vehicle

## Claims

1. An in-vehicle device comprising:
a power converter (10V) to be arranged in a compartment of a vehicle (V) and converting electric power between a travel motor (10M) and a battery (20); and
a protector (60) that is attached to the power converter (10V) and protects the power converter (10V) against interference with peripheral equipment (26) during a vehicle collision, wherein
the power converter (10V) includes: an opening (48); an electrical connection portion (33) that is provided on an inside accessible through the opening (48); and a detachable lid member (50) that closes the opening (48), and
the protector (60) is provided to block an access path to the lid member (50).

2. The in-vehicle device according to claim 1, wherein
the protector (60) is provided to block an access path to a fixing member (B4) that fixes the lid member (50).

3. The in-vehicle device according to claim 1 or 2, wherein
the protector (60) is fixed to at least two points including the lid member (50) and a protector attachment portion (47) that is provided in a place other than the lid member (50) in the power converter (10V).

4. The in-vehicle device according to any one of claims 1-3, wherein
the protector (60) is fixed to the lid member (50) at a position different from a position at which the lid member (50) is fixed to the power converter (10V).

5. The in-vehicle device according to claim 3 or 4, wherein
when the protector attachment portion (47) is defined as a first protector attachment portion (47),
the lid member (50) has a second protector attachment portion (54) that is a portion in which the protector (60) is fixed to the lid member (50), and which is formed to have lower rigidity than another portion of the lid member (50) in a manner to be deformed during interference between the peripheral equipment (26) and the protector (60).

6. The in-vehicle device according to any one of claims 1-5, wherein
the protector (60) has a priority interference portion (66) for preferential interference with the peripheral equipment (26) during the vehicle collision, and
in the power converter (10V), the electrical connection portion (33) is provided at a position away from the priority interference portion (66).

7. The in-vehicle device according to any one of claims 1 to 6, wherein
the protector (60) has an interference portion (66) that is a portion interfering with the peripheral equipment (26) during the vehicle collision and including a guide surface (66a) for relatively moving the peripheral equipment (26) in an up-down direction, and
a/the protector attachment portion (47) is provided below the interference portion (66).

8. The in-vehicle device according to claim 7, wherein the guide surface (66a) is an inclined surface.

9. The in-vehicle device according to any one of claims 1 to 8, wherein
the power converter (10V) includes a temporary placement portion (49b) of the lid member (50),
the lid member (50) is fixed in a state of being temporarily placed on the temporary placement portion (49b), and
the temporary placement portion (49b) is provided to allow displacement of the lid member (50) in only one direction that is an attachment/detachment direction.

10. The in-vehicle device according to anyone of claims 1-9, wherein
the protector (60) comprises a baffle plate (62), which extends along the power converter (10V) in a width direction,
said baffle plate (62) comprising a cover portion (63a), wherein
the cover portion (63a) of the baffle plate (62) covers the lid member (50) at least partially.

11. The in-vehicle device according to claim 10, wherein
the baffle plate (62) further comprises a coupling portion (63b) and a fixed portion (63c), said coupling portion (63b) coupling the cover portion (63a) and the fixed portion (63c), wherein
the coupling portion (63b) is oblique relative to the cover portion (63a) and relative to the fixed portion (63c).

12. The in-vehicle device according to claim 10 or 11, wherein
the lid member (50) comprises more than one fixing member (B4), preferably four fixing members (B4), for fixing the lid member (50), and
the cover portion (63a) of the baffle plate (62) covers at least one of the fixing members (B4).

13. The in-vehicle device according to any one of claims 10 to 12, wherein
the fixed portion (63c) comprises paired fixed pieces (68), and optionally a support piece (69),
the fixed portion (63c) being fixed to a/the protector attachment portion (47), which is provided in a place other than the lid member (50) in the power converter (10V), via the fixed pieces (68), wherein
the interference portion (66) of the protector (60) is joined to said fixed pieces (68), and optionally to the support piece (69).

14. The in-vehicle device according to anyone of claims 1 to 13, wherein the protector (60) has a substantially crank-like shape in a plan view.

15. A vehicle (V) comprising a travel motor (10M), a battery (20) and an in-vehicle device according to any one of claims 1 to 14.
